**Europäisches Patentamt**

**European Patent Office**

**Office européen des brevets**

(19)

(11) Veröffentlichungsnummer : **0 129 901**
**B1**

(12)

# EUROPÄISCHE PATENTSCHRIFT

(45) Veröffentlichungstag der Patentschrift :
09.09.87

(51) Int. Cl.⁴ : **G 03 F 7/10**

(21) Anmeldenummer : **84107279.6**

(22) Anmeldetag : **25.06.84**

(54) **Lichtempfindliches, wasserentwickelbares Aufzeichnungsmaterial für die Herstellung von Druck-, Reliefformen und Resistmustern.**

(30) Priorität : **25.06.83 DE 3322994**

(43) Veröffentlichungstag der Anmeldung :
**02.01.85 Patentblatt 85/01**

(45) Bekanntmachung des Hinweises auf die Patenterteilung : **09.09.87 Patentblatt 87/37**

(84) Benannte Vertragsstaaten :
**BE DE FR GB IT NL**

(56) Entgegenhaltungen :
**EP-A- 0 079 514**

(73) Patentinhaber : **BASF Aktiengesellschaft**
**Carl-Bosch-Strasse 38**
**D-6700 Ludwigshafen (DE)**

(72) Erfinder : **Schulz, Guenther, Dr.**
**Wasgaustrasse 24**
**D-6700 Ludwigshafen (DE)**
Erfinder : **Zuerger, Manfred**
**Holderlandstrasse 2**
**D-6920 Sinsheim (DE)**

EP 0 129 901 B1

## Beschreibung

Die Erfindung betrifft ein lichtempfindliches Aufzeichnungsmaterial für die Herstellung von Druck-, Reliefformen oder Resistmustern mit einer auf einem dimensionsstabilen Träger haftfest aufgebrachten, lichthärtbaren reliefbildenden Schicht (RS), die aus einem olefinisch ungesättigte, photopolymerisierbare bzw. photovernetzbare Seitengruppen enthaltenden Polyvinylalkohol-Derivat, einem oder mehreren Photopolymerisationsinitiatoren sowie gegebenenfalls üblichen, nicht photolymerisierbaren Hilfs- und/oder Zusatzstoffen besteht.

Mit Wasser oder wäßrigen Lösungen auswaschbare, lichtempfindliche Aufzeichnungsmaterialien für die Herstellung von photopolymeren Druck- und Reliefformen sind an sich bekannt und vielfach beschrieben (vgl. z. B. GB-A-834 337, US-A-3 877 939, DE-A-31 28 949, DE-A-31 44 905 oder US-A-4 247 624). Die photopolymerisierbare, reliefbildende Schicht dieser bekannten lichtempfindlichen Aufzeichnungsmaterialien besteht im allgemeinen aus einer einen Photoinitiator enthaltenden Mischung von einem wasserlöslichen oder wasserdispergierbaren Polyvinylalkohol oder Polyvinylalkohol-Derivat und olefinisch ungesättigten, photopolymerisierbaren Monomeren. Die Monomeren dienen in erster Linie zur Erzielung einer hinreichenden Vernetzung der lichtempfindlichen Aufzeichnungsmaterialien bei der bildmäßigen Belichtung, um eine für den Auswaschprozess hinreichende Löslichkeitsdifferenzierung zwischen den belichteten und unbelichteten Bereichen der reliefbildenden Schicht zu erzielen. Der Einsatz von photopolymerisierbaren Monomeren in den lichtempfindlichen Aufzeichnungsmaterialien macht häufig nicht nur eine teure Abluftreinigung bei der Herstellung der Aufzeichnungsmaterialien und Entsorgung der bei der Klischeeherstellung anfallenden Auswaschlösungen erforderlich, sondern bringt vielfach auch toxikologische Probleme beim Anwender mit sich. Die Handhabung solcher monomerhaltiger, lichtempfindlicher Aufzeichnungsmaterialien ist daher nicht unproblematisch und mit einem erheblichen sicherheitstechnischen Aufwand verbunden. Darüber hinaus erhält man mit den meisten mit Polyvinylalkohol verträglichen Monomeren, z. B. den Hydroxyalkylacrylaten und -methacrylaten, relativ spröde Relief- und Druckformen, bei denen eine Wiederverwendung und ein Aufspannen auf kleine Rundzylinder kaum möglich ist.

Es sind weiterhin bereits monomerfreie, lichtempfindliche Aufzeichnungsmaterialien für die Herstellung von Relief- und Flachdruckformen vorgeschlagen worden, deren lichthärtbare, reliefbildende Schicht als wesentlichen Bestandteil ein Polyvinylalkohol-Derivat mit seitenständigen, olefinisch ungesättigte Doppelbindungen enthaltenden Gruppen, beispielsweise Acryloyl- oder Methacryloyl-Gruppen, enthält (vgl. z. B. US-A-2 929 710, GB-A-786 119 und DE-A-15 22 359). Die gemäß diesen Druckschriften in monomerfreien lichtempfindlichen Aufzeichnungsmaterialien einzusetzenden Polyvinylalkohol-Derivate sind so weitgehend modifiziert, daß sie nicht mehr in Wasser löslich oder dispergierbar sind, so daß diese lichtempfindlichen Aufzeichnungsmaterialien nach der bildmäßigen Belichtung mit organischen Lösungsmitteln ausgewaschen werden müssen. Dem Einsatz von Wasser oder wäßrigen Lösungsmitteln zur Entwicklung der Relief- oder Druckformen ist jedoch der Vorzug zu geben.

Der vorliegenden Erfindung lag die Aufgabe zugrunde, lichthärtbare Aufzeichnungsmaterialien für die Herstellung von Druck-, Reliefformen oder Resistmustern aufzuzeigen, bei denen sich nach der bildmäßigen Belichtung mit aktinischem Licht das Bild einfach und leicht mit Wasser oder wäßrigen Lösungen entwickeln läßt, die jedoch die Nachteile der bekannten monomerhaltigen, wasserentwickelbaren Aufzeichnungsmaterialien, insbesondere bezüglich der Handhabung und Verträglichkeit, nicht aufweisen und die dennoch im belichteten Zustand eine hohe Beständigkeit gegenüber Wasser besitzen. Die lichtempfindlichen Aufzeichnungsmaterialien sollen darüber hinaus einfach und leicht herstellbar sein, gute Belichtungseigenschaften und ein hohes Auflösungsvermögen aufweisen, so daß beim Auswaschen als auch beim Druck feine Linien und Raster sehr gut reproduziert werden können ; die mit den lichtempfindlichen Aufzeichnungsmaterialien hergestellten Reliefformen oder Resistmuster sollen biegsam sein, dennoch eine für den Druck, insbesondere im Akzidenzbereich hinreichende Härte besitzen, eine gute gleichmäßige Oberfläche und eine gut ausgeprägte Reliefstruktur aufweisen.

Es wurde nun überraschend gefunden, daß diese Aufgabe durch lichtempfindliche Aufzeichnungsmaterialien mit einer auf einem Träger haftfest aufgebrachten, lichthärtbaren reliefbildenden Schicht gelöst wird, deren monomerfreie reliefbildende Schicht als alleinige photopolymerisierbare bzw. photovernetzbare Komponente ein spezielles Polyvinylalkohol-Derivat mit olefinisch ungesättigten, photopolymerisierbaren bzw. photovernetzbaren Seitengruppen enthält.

Gegenstand der Erfindung ist demzufolge ein lichtempfindliches Aufzeichnungsmaterial für die Herstellung von Druck-, Reliefformen oder Resistmustern mit einer auf einem dimensionsstabilen Träger aufgebrachten, lichthärtbaren reliefbildenden Schicht (RS), bestehend aus

a) einem olefinisch ungesättigte, photopolymerisierbare bzw. photovernetzbare Seitengruppen enthaltenden Polyvinylalkohol-Derivat,

b) mindestens einem Photopolymerisationsinitiator
sowie gegebenenfalls

c) üblichen, nicht photopolymerisierbaren Hilfs- und/oder Zusatzstoffen, welches dadurch gekennzeichnet ist, daß die lichthärtbare reliefbildende Schicht (RS) als Komponente (a) ein wasserlösliches oder wasserdispergierbares Polyvinylalkohol-Derivat enthält, welches mindestens 65 Mol-% an freien Hydroxylgruppen, 1 bis 12 Mol-% an olefinisch ungesättigten, photopolymerisierbaren bzw. photovernetzbaren Seitengruppen und bis zu 30 Mol-% an mit anderen Resten ohne olefinische Unsättigungen veresterten und/oder veretherten Hydroxylgruppen enthält.

Im Hinblick auf den bekannten Stand der Technik war es überraschend und für einen Fachmann nicht vorhersehbar, daß trotz des vergleichsweise sehr niedrigen Gehalts an olefinische Doppelbindungen enthaltenden Seitengruppen in dem Polyvinylalkohol-Derivat die erfindungsgemäßen lichtempfindlichen Aufzeichnungsmaterialien eine sehr gute, auch in den feinsten Elementen exakte und vorlagengetreue Bildreproduktion erlauben, nach der Belichtung zu Produkten führen, die eine hohe, im Vergleich zu bisher bekannten Produkten häufig sogar noch verbesserte Wasserbeständigkeit haben, ausgezeichnete Druckergebnisse auch bei sehr großen Auflagehöhen liefern und eine gute Wiederverwendbarkeit besitzen, ohne daß der Einsatz von zusätzlichen Monomeren notwendig oder erforderlich wäre. Im Vergleich zu den bekannten monomerfreien lichtempfindlichen Aufzeichnungsmaterialien auf Basis von lichthärtbaren Polyvinylalkohol-Derivaten sind die erfindungsgemäßen lichtempfindlichen Aufzeichnungsmaterialien nicht nur wasserentwickelbar, sondern zeigen auch andere wesentliche anwendungstechnische Vorteile, wie z. B. bessere Zwischentiefen in gerasterten Halbtonflächen und Negativ-Linien.

Als Träger für die erfindungsgemäßen lichtempfindlichen Aufzeichnungsmaterialien kommen die für die Herstellung von Druck-, Reliefformen oder Resistmustern üblichen und bekannten, dimensionsstabilen, starren oder flexiblen Träger in Betracht. Hierzu gehören insbesondere dimensionsstabile Kunststoff-Folien, wie z. B. Polyesterfolien, sowie metallische Träger, z. B. Stahlbleche, Eisenbleche oder Aluminiumbleche. Für die Herstellung von Resistschichten können auch Kupfer, kupferbeschichtete Materialien, gedruckte Schaltungen etc. als Trägermaterialien für die lichtempfindliche reliefbildende Schicht (RS) Anwendung finden. Die Träger, insbesondere die metallischen Träger, können in an sich bekannter Art mechanisch, chemisch und/oder durch Versehen mit einer Haftgrundierung vorbehandelt sein. Zur Erzielung einer hinreichenden Haftfestigkeit zwischen Träger und lichthärtbarer reliefbildender Schicht (RS) können, insbesondere bei lichtempfindlichen Aufzeichnungsmaterialien für die Herstellung von Druck- und Reliefformen, zwischen dem Träger und der lichthärtbaren reliefbildenden Schicht (RS) eine oder mehrere Haftschichten angeordnet sein. Die Wahl des Trägermaterials richtet sich vornehmlich nach dem vorgesehenen Anwendungszweck der lichtempfindlichen Aufzeichnungsmaterialien. Für die Haftschichten zwischen Träger und reliefbildender Schicht (RS) kommen die üblichen und bekannten, in der einschlägigen Literatur beschriebenen Materialien in Betracht.

Die lichthärtbare reliefbildende Schicht (RS) der erfindungsgemäßen lichtempfindlichen Aufzeichnungsmaterialien enthält als Komponente (a) ein wasserlösliches oder wasserdispergierbares Polyvinylalkohol-Derivat mit olefinisch ungesättigte, photopolymerisierbare bzw. photovernetzbare Doppelbindungen enthaltenden Seitengruppen. Unter Polyvinylalkoholen werden im Rahmen dieser Erfindung dabei ganz allgemein in Wasser lösliche oder zumindest dispergierbare Polymere mit wiederkehrenden —$CH_2CH(OH)$— Struktureinheiten in der Polymerhauptkette verstanden. Hierzu gehören Polyvinylalkohol selber, Copolymere aus Vinylalkohol- und anderen Comonomereinheiten, sowie Derivate, z. B. Ether und/oder Ester, von Polyvinylalkoholen. Insbesondere kommen als Polyvinylalkohole, die den erfindungsgemäß einzusetzenden Polyvinylalkohol-Derivaten zugrundeliegen, die bekannten teilverseiften Polyvinylester von Monocarbonsäuren mit 2 bis 4 Kohlenstoffatomen, vor allem die teilverseiften Polyvinylacetate und/oder Polyvinylpropionate, in Betracht. Der Verseifungsgrad dieser teilverseiften Polyvinylester liegt — vor der Derivatisierung mit den olefinisch ungesättigten Seitengruppen sowie gegebenenfalls anderen Resten — vorteilhafterweise über 70 Mol-%, vorzugsweise im Bereich von 80 bis 95 Mol-%. Zu den Polyvinylalkoholen sind auch modifizierte Polyvinylalkohole bzw. modifizierte teilverseifte Polyvinylester zu rechnen, wie z. B. die Ethylenoxideinheiten enthaltenden Copolymeren von Polyvinylalkohol oder teilverseiftem Polyvinylacetat, wobei diese Copolymeren beispielsweise 10 bis 30 Gew.%, bezogen auf das Copolymere, an chemisch gebundenen Ethylenoxideinheiten enthalten können.

Die erfindungsgemäß als Komponente (a) einzusetzenden wasserlöslichen oder wasserdispergierbaren Polyvinylalkohol-Derivate sollen 1 bis 12 Mol-% an Seitengruppen mit olefinisch ungesättigten, photopolymerisierbaren bzw. photovernetzbaren Doppelbindungen enthalten. Bevorzugt sind Seitengruppen mit aktivierten olefinischen Doppelbindungen, insbesondere Doppelbindungen, die in Konjugation oder Nachbarschaft zu Sauerstoff oder Stickstoff stehen. Besonders vorteilhaft sind die Polyvinylalkohol-Derivate, in denen sich die olefinisch ungesättigten Seitengruppen von α,β-olefinisch ungesättigten Mono- oder Dicarbonsäuren mit 3 bis 10 C-Atomen, insbesondere mit 3 oder 4 C-Atomen, ableiten, wie z. B. von Maleinsäure, Crotonsäure und insbesondere von Acrylsäure und/oder Methacrylsäure. Die Seitengruppen mit den photopolymerisierbaren bzw. photovernetzbaren olefinischen Doppelbindungen sind vorzugsweise über Ether- oder Ester-Bindungen an die Polymerhauptkette des Polyvinylalkohols gebunden. Polyvinylalkohol-Derivate mit über Etherbindungen verknüpften olefinisch ungesättigten Seitengruppen erhält man beispielsweise durch Veretherungsreaktion der Polyvinylalkohole mit hydroxylgruppenhaltigen Monomeren, insbesondere hydroxylgruppenhaltigen Derivaten der vorerwähnten α,β-olefinisch ungesättigten Carbonsäuren, wie z. B. N-Methylol-acrylamid, N-Methylol-methacrylamid, Hydroxyalkyl-(meth)acrylate, wie β-Hydroxyethyl-(meth)acrylat. Die olefinisch ungesättigten Seitengruppen können in den Polyvinylalkohol auch durch Veresterung mit entsprechenden Acylierungsmitteln, wie insbesondere den Carbonsäureanhydriden von α,β-olefinisch ungesättigten Carbonsäuren der genannten Art ein geführt werden. Besonders vorteilhaft sind Polyvinylalkohol-Derivate, die durch Acylierung von Polyvinylalkoholen mit Acrylsäureanhydrid und/oder Methacrylsäureanhydrid enthalten worden sind.

Neben den olefinisch ungesättigten Seitengruppen können die erfindungsgemäß als Komponente (a) einzusetzenden wasserlöslichen oder wasserdispergierbaren Polyvinylalkohol-Derivate auch noch bis zu 30 Mol-% an umgesetzten Hydroxylgruppen enthalten, die mit anderen Resten ohne olefinische Unsättigungen verestert und/oder verethert sind, wobei die Polyvinylalkohol-Derivate jedoch noch mindestens 65 Mol-% an freien Hydroxylgruppen enthalten sollen. Bei diesen anderen Seitengruppen ohne olefinische Unsättigungen handelt es sich in erster Linie um Acyl-Gruppen von gesättigten aliphatischen oder aromatischen Carbonsäuren. Im Fall der bevorzugt eingesetzten teilverseiften Polyvinylacetate oder Polyvinylpropionaten sind dies insbesondere die restlichen Acetyl- oder Propionyl-Gruppen. Es können durch zusätzliche Veresterung oder Veretherung von Hydroxylgruppen der Polyvinylalkohole aber auch noch andere Reste, z. B. mit funktionellen Gruppen, in den Polyvinylalkohol eingebaut werden. Beispielsweise ist es möglich, durch Acylierung des Polyvinylalkohols mit aktivierten Carbonsäurederivaten von 2- oder mehrbasischen Carbonsäuren, wie z. B. Bernsteinsäureanhydrid oder Phthalsäureanhydrid, unter Bildung der Halbester dieser mehrbasischen Carbonsäuren Polyvinylalkohol-Derivate mit Seitengruppen herzustellen, die freie Carboxyl-Gruppen enthalten.

Vorzugsweise enthalten die erfindungsgemäß einzusetzenden Polyvinylalkohol-Derivate 75 bis 90 Mol-% freie Hydroxyl-Gruppen, 2 bis 10 Mol-% der Seitengruppen mit den photopolymerisierbaren bzw. photovernetzbaren olefinischen Doppelbindungen und 5 bis 20 Mol-% an anderen Seitengruppen ohne olefinische Unsättigungen. Im allgemeinen kann in den wasserlöslichen oder wasserdispergierbaren Polyvinylalkohol-Derivaten der Anteil der olefinisch ungesättigten Seitengruppen umso höher liegen, je niedriger der Gehalt an anderen Seitengruppen ohne olefinische Unsättigungen ist. Umgekehrt wird für den Fall, daß der Anteil der Seitengruppen ohne olefinische Unsättigungen im oberen Bereich der angegebenen Grenzen liegt, der Anteil der olefinisch ungesättigten Seitengruppen in den Polyvinylalkohol-Derivaten niedriger gehalten werden.

Das mittlere Molekulargewicht (Zahlenmittel) der Polyvinylalkohol-Derivate liegt im allgemeinen im Bereich von 10 000 bis 200 000, vorzugsweise im Bereich von 15 000 bis 100 000. Die Wahl der Polyvinylalkohol-Derivate richtet sich insbesondere nach dem Anwendungszweck der lichtempfindlichen Aufzeichnungsmaterialien, sowie dem gewünschten Eigenschaftsbild der hieraus hergestellten Druck-, Reliefformen oder Resistmuster. Als Komponente (a) können in der lichthärtbaren reliefbildenden Schicht (RS) der erfindungsgemäßen Aufzeichnungsmaterialien auch mehrere verschiedenartige Polyvinylalkohol-Derivate der in Rede stehenden Art enthalten sein.

Auch wenn die Herstellung der erfindungsgemäß einzusetzenden Polyvinylalkohol-Derivate mit den olefinisch ungesättigten Seitengruppen an und für sich in jeder beliebigen und bekannten Art und Weise vorgenommen werden kann, haben sich für den erfindungsgemäßen Einsatz die Polyvinylalkohol-Derivate als besonders günstig herausgestellt, die durch Acylierung von Polyvinylalkoholen in heterogener Phase mit olefinisch ungesättigte, photopolymerisierbare bzw. photovernetzbare Gruppen enthaltenden Acylierungsmitteln hergestellt worden sind. Als Acylierungsmittel sind hierbei die aktivierten Carbonsäurederivate, insbesondere die Carbonsäureanhydride, der α,β-olefinisch ungesättigten Carbonsäuren mit 3 bis 10 C-Atomen, vorzugsweise mit 3 oder 4 C-Atomen, besonders vorteilhaft. Bevorzugte Acylierungsmittel für die Derivatisierung der Polyvinylalkohole in heterogener Phase sind neben Crotonsäureanhydrid und Maleinsäureanhydrid insbesondere Acrylsäureanhydrid und/oder Methacrylsäureanhydrid.

Die Acylierung der Polyvinylalkohole mit den olefinische Doppelbindungen enthaltenden Acylierungsmitteln in heterogener Phase kann dabei beispielsweise gemäß dem in der DE-A-31 44 905 beschriebenen Verfahren unter Einsatz eines großen Überschusses des Acylierungsmittels, der mindestens dem 2 molar-fachen des gewünschten Acylierungsgrades entspricht, durchgeführt werden. Ganz besonders vorteilhaft wird die Derivatisierung der Polyvinylalkohole mit den olefinisch ungesättigten Acylierungsmitteln jedoch in heterogener Phase in Gegenwart von p-Aminopyridinen als Katalysator durchgeführt. Als Katalysator kommen insbesondere die an der Aminogruppe mit Alkylgruppen oder mit einem cyclischen Alkylenrest disubstituierten p-Aminopyridine, insbesondere das p-Dimethylaminopyridin und p-Pyrrolidinopyridin in Betracht. Die Katalysatorkonzentration liegt vorzugsweise im Bereich zwischen 0,1 bis 15 Gew.%, insbesondere im Bereich von 0,5 bis 5 Gew.%, an p-Aminopyridin, bezogen auf den eingesetzten Polyvinylalkohol. Zusätzlich zu dem p-Aminopyridin-Katalysator können bei der Acylierung in heterogener Phase noch andere tertiäre Amine, wie beispielsweise Pyridin oder Triethylamin, als Hilfsbasen in einer Menge bis zu 50 Gew.%, vorzugsweise zwischen 5 und 20 Gew.%, bezogen auf den eingesetzten Polyvinylalkohol, mitverwendet werden. Im Fall der mit den p-Aminopyridinen katalysierten Acylierung der Polyvinylalkohole in heterogener Phase kann die Menge des Acylierungsmittels so bemessen werden, daß sie der 1,1- bis 1,5-fachen molaren Menge entspricht, die für den gewünschten Umsetzungsgrad notwendig ist. Die Umsetzung der Polyvinylalkohole zu den Polyvinylalkohol-Derivaten mit den olefinisch ungesättigten Seitengruppen durch Acylierung in heterogener Phase wird vorteilhafterweise so durchgeführt, daß man den Polyvinylalkohol in einem aprotischen Dispergiermittel aufschlämmt und in dieser Aufschlämmung — gegebenenfalls in Gegenwart der p-Aminopyridine als Katalysator — unter gleichzeitiger kräftiger Durchmischung mit dem Acylierungsmittel umsetzt. Als aprotische Dispergiermittel kommen insbesondere niedere halogenierte Kohlenwasserstoffe, niedere aliphatische Ketone und aliphatische, cycloaliphatische und/oder aromatische Kohlenwasserstoff-Lösungsmittel in Betracht, wie beispielsweise Methylenchlorid, Chloroform, Tetrachlorkohlenstoff, Trichlorethan ; Aceton, Methylethylketon, Methylisobutylketon ; Hexan, Cyclohexan, Benzinfraktionen ; Benzol, Xylol und vorzugsweise Toluol. Die Reaktionstemperatur liegt im allgemeinen im Bereich von 10 bis 100 °C und wird vorzugsweise bei 40 bis 80 °C gehalten. Es hat sich dabei als zweckmäßig erwiesen, solche Mengen an aprotischen Dispergiermitteln einzusetzen, daß in der Aufschlämmung aus Polyvinylalkohol und Dispergiermittel 30 bis 75 Gew.%, insbesondere 40 bis 65 Gew.%, des Dispergiermittels, bezogen auf die Summe von Polyvinylalkohol und Dispergiermittel, enthalten sind.

Es hat sich gezeigt, daß die Herstellung der erfindungsgemäß einzusetzenden Polyvinylalkohol-Derivate durch Acylierung von Polyvinylalkoholen in heterogener Phase im Vergleich zu anderen Herstellverfahren, beispielsweise der Umsetzung in Lösung, nicht nur einfacher und kostensparender ist, sondern darüber hinaus auch bezüglich der physikalischen und chemischen Eigenschaften zu Polyvinylalkohol-Derivaten führt, die sich mit besonderem Vorteil für den Einsatz in den lichtempfindlichen Aufzeichnungsmaterialien eignen. Beispielsweise resultieren bei Verwendung von Polyvinylalkohol-Derivaten der in Rede stehenden Art, die durch Acylierung von Polyvinylalkoholen in heterogener Phase mit p-Aminopyridinen als Katalysator hergestellt worden sind, lichtempfindliche Aufzeichnungsmaterialien, die nicht nur sehr gut wasserentwickelbar sind, sondern darüber hinaus auch eine verbesserte Wasserbeständigkeit in den nach der Belichtung gehärteten Bereichen aufweisen. Darüber hinaus sind bei solchen Aufzeichnungsmaterialien das Auflösungsvermögen, die vorlagengetreue Reproduktion, die Reliefstruktur wie auch die Oberfläche und die mechanischen Eigenschaften der Reliefschicht verbessert.

Die Einführung von anderen Seitengruppen ohne olefinische Unsättigungen in den Polyvinylalkohol, beispielsweise wie vorerwähnt von Seitengruppen mit freien Carboxylgruppen, etwa Bernsteinsäure- oder Phthalsäure-Resten, kann gleichzeitig oder auch getrennt von der Einführung der olefinisch ungesättigten Seitengruppen in einer entsprechenden Acylierungsreaktion in heterogener Phase erfolgen.

Neben den Polyvinylalkohol-Derivaten mit den olefinisch ungesättigten Seitengruppen der in Rede stehenden Art enthält die lichthärtbare reliefbildende Schicht (RS) der erfindungsgemäßen Aufzeichnungsmaterialien mindestens einen Photopolymerisationsinitiator. Als Photopolymerisationsinitiatoren, die in der lichthärtbaren reliefbildenden Schicht (RS) allein oder in Mischung miteinander eingesetzt werden können, kommen die für lichtempfindliche Gemische üblichen und an sich bekannten Photoinitiatoren in Betracht, beispielsweise Acyloine und deren Derivate, wie Benzoin, Benzoinalkylether, z. B. Benzoinisopropylether, α-Methylolbenzoin und dessen Ether, wie z. B. α-Methylolbenzoinmethylether, oder α-Methylbenzoin und α-Methylbenzoinethylether ; vicinale Diketone und deren Derivate, wie z. B. Benzil, Benzilketale, wie Benzildimethylketal, Benzilmethylethylketal, Benzilmethylbenzylketal oder Benzilethylenglykolketal ; sowie insbesondere Acylphosphinoxid-Verbindungen des Typs, wie sie z. B. in der DE-A-29 09 992 und der DE-A-31 14 341 für den Einsatz in photopolymerisierbaren Mischungen beschrieben sind. Bevorzugte Vertreter von Initiatoren aus der Klasse der Acylphosphinoxide sind 2,6-Dimethoxybenzoyl-diphenylphosphinoxid ; 2,4,6-Trimethylbenzoyl-diphenylphosphinoxid ; 2,4,6-Trimethylbenzoyl-phenylphosphinsäureethylester und 2,4,6-Trimethylbenzoyl-phenylphosphinsäure-natriumsalz. Die Photopolymerisations-initiatoren könne auch in Verbindung mit anderen Coinitiatoren und/oder Aktivatoren, wie sie in der einschlägigen Literatur beschrieben sind, verwendet werden.

Oft ist es von Vorteil, wenn die lichthärtbare reliefbildende Schicht (RS) neben dem Polyvinylalkohol-Derivat (Komponente (a)) und dem Photoinitiator (Komponente (b)) als weitere Komponente (c) andere übliche, nicht photopolymerisierbare Hilfs- und/oder Zusatzstoffe enthält. Hierzu gehören insbesondere thermische Polymerisationsinhibitoren, wie z. B. Hydrochinon, Hydrochinon-Derivate, 2,6-Di-tert.-butyl-p-kresol, Nitrophenole, N-Nitrosoamine, wie N-Nitrosodiphenylamin oder die Salze, insbesondere die Alkali- und Aluminiumsalze, des N-Nitrosocyclohexyl-hydroxylamins. Weiterhin können beispielsweise Farbstoffe, Pigmente, Waichmacher, Verarbeitungshilfsmittel etc. enthalten sein. Unter den Farbstoffen haben die löslichen Phenazinium-, Phenoxazinium-, Acridinium- und Phenotiazinium-Farbstoffe besondere Bedeutung, wie z. B. Neutralrot (C. I. 500 40), Safranin T (C. I. 502 40), Rhodanilblau, dem Salz bzw. Amid aus Rhodamin B (Basic Violett 10, C.I. 45 170), Methylenblau (C.I. 52 015), Thionin (C.I. 52 025) und Acridinorange (C.I. 46 005). Diese Farbstoffe, die im allgemeinen in Mengen von 0,0001 bis 1 Gew.%, bezogen auf die gesamte lichthärtbare reliefbildende Schicht (RS), eingesetzt werden, werden vorzugsweise zusammen mit einer hinreichenden Menge eines Reduktionsmittels verwendet, welches den Farbstoff in Abwesenheit von aktinischem Licht nicht reduziert, bei Belichtung den Farbstoff im angeregten Elektronenzustand jedoch reduzieren kann. Beispiele solcher milden Reduktionsmittel sind Ascorbinsäure, Anetol, Thioharnstoff, Diethylallylthioharnstoff, Hydroxylamin-Derivate, insbesondere N-Allylthioharnstoff und bevorzugt Salze des N-Nitrosocyclohexyl-hydroxylamins, insbesondere die Kalium- und Aluminiumsalze. Letztere können dabei, wie erwähnt, auch als Inhibitoren gegen die thermische Polymerisation in der lichthärtbaren reliefbildenden Schicht (RS) enthalten sein. Die Menge der zugesetzten Reduktionsmittel beträgt im allgemeinen etwa 0,005 bis 5 Gew.%, insbesondere 0,01 bis 1 Gew.%, bezogen auf die lichthärtbare reliefbildende Schicht (RS), wobei sich in vielen Fällen der Zusatz des 3- bis 10-fachen der Menge an mitverwendetem Farbstoff bewährt hat.

Die lichthärtbare reliefbildende Schicht (RS) der erfindungsgemäßen lichtempfindlichen Aufzeichnungsmaterialien besteht im allgemeinen aus (a) 99,9 bis 60 Gew.%, vorzugsweise 99 bis 84 Gew.%, des wasserlöslichen bzw. wasserdispergierbaren Polyvinylalkohol-Derivats mit den olefinisch ungesättigten, photopolymerisierbaren bzw. photovernetzbaren Seitengruppen, (b) 0,1 bis 5 Gew.%, vorzugsweise 0,5 bis 3 Gew.%, des Photopolymerisationsinitiators, sowie (c) 0 bis 35 Gew.%, vorzugsweise 0,1 bis 15 Gew.%, der üblichen, nicht photopolymerisierbaren Hilfs- und/oder Zusatzstoffe, wobei diese Gewichtsanteile stets auf die gesamte lichthärtbare reliefbildende Schicht (RS) bezogen sind. Die Komponenten sind dabei so aufeinander abgestimmt, daß die lichtempfindlichen Aufzeichnungsmaterialien nach der bildmäßigen Belichtung wasserentwickelbar sind. Die Dicke der lichthärtbaren reliefbildenden Schicht (RS) kann, je nach Anwendungszweck der lichtempfindlichen Aufzeichnungsmaterialien, in weiten Grenzen schwanken und wird im allgemeinen im Bereich von 25 bis 2 000 µm liegen. Für die Herstellung von Hochdruckformen und Reliefstrukturen sind Schichtdicken im Bereich von 200 bis 2 000 µm bevorzugt.

Die lichthärtbare reliefbildende Schicht (RS) kann auf dem dimensionsstabilen Träger direkt aufgebracht sein ; sie kann jedoch, wie bereits erwähnt, in Abhängigkeit von den eingesetzten Materialien auch mittels einer Haftschicht, die im allgemeinen von etwa 0,5 bis 40 µm dick ist, auf dem Träger fest verankert sein. Als Haftschichten können die hierfür üblichen und bekannten Kleber bzw. Haftlacke verwendet werden, beispielsweise 1- oder 2-Komponenten-Kleber auf Polyurethan-Basis oder Haftschichten, wie sie in der DE-A-30 15 419 beschrieben sind.

Auch wenn auf die lichthärtbare reliefbildende Schicht (RS) der erfindungsgemäßen lichtempfindlichen Aufzeichnungsmaterialien noch eine Deckschicht und/oder Schutzschicht aufgebracht werden kann, beispielsweise aus Polyvinylalkohol mit einem hohen Verseifungsgrad, so kann eine solche Deckschicht bei den erfindungsgemäßen lichtempfindlichen Aufzeichnungsmaterialien in aller Regel entfallen, da die lichthärtbare reliefbildende Schicht (RS) keine flüchtigen Bestandteile, wie z. B. Monomere, enthält, die zu Belästigungen oder speziellen Vorsichtsmaßnahmen bei der Handhabung oder Verarbeitung der lichtempfindlichen Aufzeichnungsmaterialien Anlaß geben könnten. Hierin ist ein weiterer Vorteil der erfindungsgemäßen lichtempfindlichen Aufzeichnungsmaterialien zu sehen.

Die Herstellung der erfindungsgemäßen lichtempfindlichen Aufzeichnungsmaterialien erfolgt in an sich bekannter Weise durch Herstellen und Verbinden der einzelnen Schichten. Beispielsweise kann die lichthärtbare reliefbildende Schicht (RS) durch homogenes Vermischen der Bestandteile, Pressen, Extrudieren oder Kalandrieren hergestellt und dann mit dem Träger in geeigneter Weise, beispielsweise durch Laminieren, verbunden werden. Vorteilhaft werden die Komponenten der lichthärtbaren reliefbildenden Schicht (RS) in einem Lösungsmittel, vorzugsweise Wasser, gelöst und die lichthärtbare reliefbildende Schicht (RS) durch Gießen aus dieser Lösung auf den Träger hergestellt. Die nicht glatt wasserlöslichen komponenten der lichthärtbaren reliefbildenden Schicht (RS) werden gegebenenfalls in wassermischbaren, organischen Lösungsmitteln, wie niederen Alkoholen, niederen Ketonen, Tetrahydrofuran, vorgelöst und dann mit der wäßrigen Gießlösung vereinigt. Nach dem Gießen der lichthärtbaren reliefbildenden Schicht (RS) wird das Lösungsmittel in üblicher Weise entfernt und die Schicht getrocknet.

Die erfindungsgemäßen lichtempfindlichen Aufzeichnungsmaterialien eignen sich beispielsweise für die Herstellung von Flachdruckplatten, Resisten, wie sie z. B. bei der Herstellung von gedruckten Schaltungen, integrierten Schaltkreisen, in der Halbleitertechnik, in der Ätzformtechnik Verwendung finden, sowie insbesondere zur Herstellung von Reliefstrukturen und Hochdruckformen, vor allem für den Akzidenzbereich. Hierzu wird die lichthärtbare reliefbildende Schicht (RS) der lichtempfindlichen Aufzeichnungsmaterialien in üblicher und an sich bekannter Weise bildmäßig mit aktinischem Licht belichtet und durch Auswaschen der unbelichteten, unvernetzten Schichtanteile mit Wasser oder wäßrigen Lösungen entwickelt. Für die Belichtung, die in Form einer Flach- oder Rundbelichtung erfolgen kann, eignen sich die üblichen Lichtquellen von aktinischem Licht, wie beispielsweise UV-Fluoreszenzröhren, Quecksilberhoch-, -mittel- oder -niederdruckstrahler, superaktinische Leuchtstoffröhren, Xenon-Impulslampen, Metallhalogenid-dotierte Lampen, Kohlebogenlampen. Die emitierte Wellenlänge soll im allgemeinen zwischen 230 und 450 nm, bevorzugt zwischen 300 und 420 nm liegen und auf die Eigenabsorption des mitverwendeten Photoinitiators abgestimmt sein. Das Entwickeln des Reliefbildes kann durch Sprühen, Waschen, Bürsten etc. mit dem wäßrigen Entwicklerlösungsmittel erfolgen. Wegen der großen Wasserbeständigkeit der belichteten lichtgehärteten Reliefschicht besitzen die erfindungsgemäßen Aufzeichnungsmaterialien den Vorteil, daß die Auswaschbedingungen bei der Entwicklung mit Wasser verschärft werden können, ohne daß dies zu einer Beeinträchtigung der Druck-, Reliefformen oder Resistmuster führt. Im Gegenteil lassen sich hierdurch schärfere Reliefstrukturen erhalten. Nach dem Auswaschen werden die resultierenden Druck-, Reliefformen oder Resistmuster in üblicher Weise, gegebenenfalls bei Temperaturen bis zu 120 °C getrocknet. In manchen Fällen ist es zweckmäßig, die erhaltenen Druck-, Reliefformen oder Resistmuster anschließend nochmals vollflächig mit aktinischem Licht nachzubelichten, um die Festigkeit der Reliefschicht zu erhöhen. Die erfindungsgemäßen lichtempfindlichen Aufzeichnungsmaterialien ergeben nicht nur Druck-, Reliefformen und Resistmuster mit einer außerordentlich hohen Wasserbeständigkeit, so daß sie auch in einem feucht-warmen Klima eine hohe Lagerbeständigkeit und hohe Wiederverwendbarkeit besitzen, sondern auch Produkte mit besseren Zwischentiefen und besserer Schärfe als die herkömmlichen Systeme, ausgeprägter Reliefstruktur sowie hoher Elastizität und glatter Oberfläche.

Die Erfindung wird durch die nachfolgenden Beispiele erläutert. Die in den Beispielen genannten Teile und Prozente beziehen sich, soweit nicht anders angegeben, auf das Gewicht. Die Molekulargewichte der Polyvinylalkohole (Zahlenmittel) wurden bestimmt über die Viskositäten, gemessen als 4 gew.%ige wäßrige Lösung bei 20 °C in einem Höppler-Viskosimeter.

Beispiel 1

1.1 100 Teile eines teilverseiften Polyvinylacetats (Verseifungsgrad 80 Mol-%, Molekulargewicht 25 000) wurden in 150 Teilen Aceton aufgeschlämmt und mit 50 Teilen Methacrylsäureanhydrid sowie 1 Teil 2,6-Di-tert.-butyl-P-kresol versetzt. Das inhomogene Gemisch wurde ca. 24 Stunden bei 60 °C gerührt. Danach wurde über eine Nutsche filtriert. Das erhaltene Polyvinylalkohol-Derivat enthielt 3 Mol.% Methacrylester-Seitengruppen und 20 Mol.% Acetyl-Seitengruppen (entsprechend 77 Mol.% freie Hydroxylgruppen.)

1.2 98 Teile des gemäß 1.1 hergestellten Polyvinylalkohol-Derivats wurden zusammen mit 0,2 Teilen 2,6-Di-tert.-butyl-p-kresol in 135 Teilen Wasser gelöst und mit einer Lösung von 2 Teilen Benzildimethylketal in 10 Teilen Ethanol vermischt. Hieraus wurde auf einem mit einem Polyurethan-Haftlack versehenen Stahlblech als Träger eine ca. 2 mm dicke Schicht (RS) geformt und getrocknet.

1.3 Das gemäß 1.2 hergestellte Aufzeichnungsmaterial wurde in an sich bekannter Weise zu einer Reliefdruckform verarbeitet, indem die Schicht (RS) durch Bestrahlung mit aktinischem Licht einer Wellenlänge von 360 nm durch ein Bildnegativ bildmäßig belichtet wurde und die nichtbelichteten Anteile der Schicht (RS) mit Wasser ausgewaschen wurden. Die erhaltene Druckform wurde danach getrocknet und vollflächig mit aktinischem Licht der gleichen Wellenlänge nachbelichtet. Die resultierende Druckform zeigte bei exakter Bildwiedergabe und hoher Flexibilität ausgezeichnete Druckeigenschaften.

Vergleichsversuch A

Zu einer Lösung von 58 Teilen des gemäß Beispiel 1.1 hergestellten Polyvinylalkohol-Derivats in 60 Teilen Wasser wurde eine Mischung aus 34 Teilen β-Hydroxyethylmethacrylat, 6 Teilen Tetraethylenglykoldimethacrylat, 2 Teilen Benzildimethylketal und 0,2 Teilen 2, 6-Di-tert. butyl-p-kresol gegeben. Aus dieser Lösung wurde entsprechend wie in Beispiel 1.2 durch Vergießen auf einem Stahlblech ein lichtempfindliches Aufzeichnungsmaterial hergestellt, welches entsprechend Beispiel 1.3 zu einer Reliefdruckform verarbeitet wurde. Die so erhaltene Druckform war erheblich spröder als das nach Beispiel 1 erhaltene Produkt.

Beispiel 2

2.1 100 Teile eines teilverseiften Polyvinylacetats (Verseifungsgrad 88 Mol-%, mittleres Molekulargewicht ca. 30 000) wurden in einer Mischung aus 180 Teilen Toluol, 20 Teilen Acrylsäureanhydrid, 1 Teil p-Dimethylaminopyridin sowie 1 Teil 2, 6-Di-tert.-butyl-p-kresol dispergiert und 12 Stunden lang bei 80 °C gerührt. Das unlösliche Reaktionsprodukt wurde abfiltriert, mit Toluol und Aceton gewaschen und getrocknet. Das erhaltene Polyvinylalkohol-Derivat enthielt in gebundener Form 5 Mol-% Acrylester-Seitengruppen und 12 Mol-% Acetyl-Seitengruppen (entsprechend 83 Mol-% freier Hydroxyl-Gruppen).

2.2 Mit dem gemäß 2.1 hergestellten Polyvinylalkohol-Derivat wurde entsprechend Beispiel 1.2 eine wäßrige Lösung aus 98 Teilen des Polyvinylalkohol-Derivats, 2 Teilen Benzildimethylketal, 0,2 Teilen 2,6-Di-tert.-butyl-p-kresol in 135 Teilen Wasser hergestellt und aus dieser Lösung auf einem mit einem Polyurethan-Haftlack versehenen Stahlblech als Träger eine ca. 1,4 mm starke Schicht (RS) geformt.

2.3 Das so erhaltene Aufzeichnungsmaterial wurde durch bildmäßiges Belichten mit aktinischem Licht, Auswaschen der unbelichteten Bestandteile der Schicht (RS) mit Wasser sowie Trocknen entsprechend der Arbeitsweise von Beispiel 1.3 zu einer Reliefdruckform verarbeitet, die sich mit besonderem Vorteil für den Akzidenzdruck einsetzen ließ.

Die erhaltene Reliefdruckform zeichnete sich durch hohe Wasserbeständigkeit, gute mechani-

sche Stabilität und scharfe Flanken der Reliefstrukturen aus. Es kann auch auf die Nachbelichtung verzichtet werden.

Beispiel 3

Es wurde wie in Beispiel 2 verfahren, bei der Herstellung der lichtempfindlichen Schicht (RS) anstelle des Di-tert.-butyl-p-kresol 0,2 Teile des Kaliumsalzes des N-Nitrosocyclohexylhydroxylamins sowie zusätzlich 0,02 Teile Safranin T (C. I. 50 240) eingesetzt. Es wurde eine Reliefform mit verbesserten Zwischentiefen und Reliefstruktur erhalten. Der Belichtungsspielraum des Aufzeichnungsmaterials war größer ; es konnten kürzere Belichtungszeiten gewählt werden.

**Patentansprüche**

1. Lichtempfindliches Aufzeichnungsmaterial für die Herstellung von Druck-, Reliefformen oder Resistmustern mit einer auf einem dimensionssta-bilen Träger aufgebrachten, lichthärtbaren re-liefbildenden Schicht, bestehend aus

a) einem olefinisch ungesättigte, photopoly-merisierbare bzw. photovernetzbare Seitengrup-pen enthaltenden Polyvinylalkohol-Derivat,
b) mindestens einem Photopolymerisationsinitiator
sowie gegebenenfalls
c) üblichen, nicht-photopolymerisierbaren Hilfs- und/oder Zusatzstoffen,

dadurch gekennzeichnet, daß die lichthärtbare reliefbildende Schicht als Komponente (a) ein wasserlösliches oder wasserdispergierbares Polyvinylalkohol-Derivat enthält, welches mindestens 65 Mol-% an freien Hydroxylgruppen, 1 bis 12 Mol-% an olefinische, photopolymerisierbare bzw. photovernetzbare Doppelbindungen enthaltenden Seitengruppen und bis zu 30 Mol-% an mit anderen Resten ohne olefinische Unsättigungen veresterten und/oder veretherten Hydroxyl-Gruppen enthält.

2. Lichtempfindliches Aufzeichnungsmaterial gemäß Anspruch 1, dadurch gekennzeichnet, daß das wasserlösliche oder wasserdispergierbare Polyvinylalkohol-Derivat 75 bis 90 Mol-% an freien Hydroxyl-Gruppen, 2 bis 10 Mol-% der olefinisch ungesättigten, photopolymerisierbaren bzw. photovernetzbaren Seitengruppen und 5 bis 20 Mol-% der anderen Seitengruppen ohne olefinische Unsättigungen enthält.

3. Lichtempfindliches Aufzeichnungsmaterial nach einem der Ansprüche 1 oder 2, dadurch gekennzeichnet, daß sich das wasserlösliche oder wasserdispergierbare Polyvinylalkohol-Derivat von einem teilverseiften Polyvinylester von Monocarbonsäuren mit 2 bis 4 C-Atomen, insbesondere von einem teilverseiften Polyvinylacetat oder Polyvinylpropionat, ableitet.

4. Lichtempfindliches Aufzeichnungsmaterial nach einem der Ansprüche 1 bis 3, dadurch gekennzeichnet, daß es sich bei den in dem Polyvinylalkohol-Derivat enthaltenen olefinisch ungesättigten, photopolymerisierbaren bzw. photovernetzbaren Gruppen um Reste oder Derivate von α,β-olefinisch ungesättigten Carbonsäuren mit 3 bis 10 C-Atomen, insbesondere der Acryl-, Methacryl-, Croton- oder Maleinsäure, handelt.

5. Lichtempfindliches Aufzeichnungsmaterial nach Anspruch 4, dadurch gekennzeichnet, daß die lichthärtbare reliefbildende Schicht als Komponente (a) ein wasserlösliches oder wasserdispergierbares Polyvinylalkohol-Derivat enthält, welches erhalten worden ist durch Umsetzung eines teilverseiften Polyvinylacetats oder Polyvinylpropionats mit dem Anhydrid einer α, β-olefinisch ungesättigten Carbonsäure mit 3 bis 10 C-Atomen in heterogener Phase in Gegenwart von in der Aminogruppe disubstituierten p-Ami-nopyridinen, insbesondere p-Dialkylaminopyridi-nen und/oder p-Pyrrolidinopyridin, als Katalysator.

6. Lichtempfindliches Aufzeichnungsmaterial nach einem der Ansprüche 1 bis 5, dadurch gekennzeichnet, daß das Polyvinylalkohol-Derivat zusätzlich freie Carboxylgruppen enthält.

7. Lichtempfindliches Aufzeichnungsmaterial nach einem der Ansprüche 1 bis 6, dadurch gekennzeichnet, daß das mittlere Molekulargewicht der Polyvinylalkohol-Derivate im Bereich von 10 000 bis 200 000 liegt.

8. Lichtempfindliches Aufzeichnungsmaterial nach einem der Ansprüche 1 bis 7, dadurch gekennzeichnet, daß die lichthärtbare reliefbildende Schicht besteht aus

a) 99,9 bis 60 Gew.% des wasserlöslichen oder wasserdispergierbaren Polyvinylalkohol-Derivats,
b) 0,1 bis 5 Gew.% an Photoinitiatoren sowie
c) 0 bis 35 Gew.% an üblichen, nicht photopolymerisierbaren Hilfs- und/oder Zusatzstoffen.

**Claims**

1. A photosensitive recording material for the production of printing plates, relief plates or resist images, comprising a photocurable relief-forming layer which is applied to a dimensionally stable base and consists of

a) a polyvinyl alcohol derivative containing olefinically unsaturated, photopolymerizable or photocrosslinkable side groups, and
b) at least one photopolymerization initiator, with or without
c) conventional non-photopolymerizable assistants and/or additives,
wherein the photocurable relief-forming layer contains, as component (a), a water-soluble or water-dispersible polyvinyl alcohol derivative which contains at least 65 mole % of free hydroxyl groups, from 1 to 12 mole % of side groups possessing olefinic photopolymerizable or photocrosslinkable double bonds, and from 0 to 30 mole % of hydroxyl groups which are esterified and/or etherified with other, non-olefinic radicals.

2. A photosensitive recording material as claimed in claim 1, wherein the water-soluble or water-dispersible polyvinyl alcohol derivative contains from 75 to 90 mole % of free hydroxyl groups, from 2 to 10 mole % of olefinically unsaturated photopolymerizable or photocrosslinkable side groups, and from 5 to 20 mole % of other non-olefinic side groups.

3. A photosensitive recording material as claimed in claim 1, wherein the water-soluble or water-dispersible polyvinyl alcohol derivative is derived from a partially hydrolyzed polyvinyl ester of a monocarboxylic acid of 2 to 4 carbon atoms, especially from a partially hydrolyzed polyvinyl acetate or polyvinyl propionate.

4. A photosensitive recording material as claimed in any of claims 1 to 3, wherein the olefinically unsaturated photopolymerizable or photocrosslinkable groups present in the polyvinyl alcohol derivative are radicals or derivatives of $\alpha,\beta$-olefinically unsaturated carboxylic acids of 3 to 10 carbon atoms, especially acrylic acid, methacrylic acid, crotonic acid or maleic acid.

5. A photosensitive recording material as claimed in claim 4, wherein the photocurable relief-forming layer contains, as component (a), a water-soluble or water-dispersible polyvinyl alcohol derivative which has been obtained by reacting a partially hydrolyzed polyvinyl acetate or polyvinyl propionate with an anhydride of an $\alpha,\beta$-olefinically unsaturated carboxylic acid of 3 to 10 carbon atoms in the heterogeneous phase in the presence of, as catalyst, a paminopyridine which is disubstituted at the amino group, especially a p-dialkylaminopyridine and/or p-pyr-rolidinopyridine.

6. A photosensitive recording material as claimed in any of claims 1 to 5, wherein the polyvinyl alcohol derivative additionally contains free carboxyl groups.

7. A photosensitive recording material as claimed in any of claims 1 to 6, wherein the mean molecular weight of the polyvinyl alcohol derivative is from 10 000 to 200 000.

8. A photosensitive recording material as claimed in any of claims 1 to 7, wherein the photocurable relief-forming layer consists of

a) from 99.9 to 60 % by weight of the water-soluble or water-dispersible polyvinyl alcohol derivative,

b) from 0.1 to 5 % by weight of photoinitiators, and

c) from 0 to 35 % by weight of conventional non-photopolymerizable assistants and/or additives.

## Revendications

1. Matériau d'enregistrement photosensible pour la fabrication de plaques d'impression, de formes en relief ou de réserves avec une couche photodurcissable, destinée à former le relief, déposée sur un support dimensionnellement stable, cette couche étant composée de

a) un dérivé d'alcool polyvinylique à insaturation oléfinique, comprenant des groupes latéraux photopolymérisables ou réticulables,

b) au moins un amorceur de la photopolymérisation et éventuellement

c) des additifs et(ou) adjuvants non photopolymérisables usuels,

caractérisé en ce que la couche photodurcissable, destinée à former le relief, contient en tant que composant (a) un dérivé d'alcool polyvinylique hydrosoluble ou dispersible dans l'eau, qui comprend au moins 65 % molaires de groupes hydroxyle libres, entre 1 et 12 % molaires de groupes latéraux à doubles liaisons oléfiniques photopolymérisables ou réticulables et jusqu'à 30 % molaires de groupes hydroxyle estérifiés et(ou) éthérifiés par d'autres groupes exempts d'insaturation oléfinique.

2. Matériau d'enregistrement photosensible suivant la revendication 1, caractérisé en ce que le dérivé d'alcool polyvinylique hydrosoluble ou dispersible dans l'eau contient entre 75 et 90 % molaires de groupes hydroxyle libres, entre 2 et 10 % molaires de groupes latéraux à insaturation oléfinique photopolymérisables ou réticulables et entre 5 et 20 % molaires d'autres groupes latéraux exempts d'insaturation oléfinique.

3. Matériau d'enregistrement photosensible suivant l'une des revendications 1 et 2, caractérisé en ce que le dérivé d'alcool polyvinylique hydrosoluble ou dispersible dans l'eau dérive d'un ester polyvinylique, partiellement saponifié, d'acides mono-carboxyliques en $C_2$ à $C_4$, en particulier d'un poly(acétate de vinyle) ou d'un poly(propionate de vinyle) partiellement saponifié.

4. Matériau d'enregistrement photosensible suivant l'une des revendications 1 à 3, caractérisé en ce que les groupes à insaturation oléfinique photopolymérisables ou réticulables, contenus dans le dérivé d'alcool polyvinylique, sont des restes ou dérivés d'acides carboxyliques à insaturation $\alpha,\beta$-oléfinique en $C_3$ à $C_{10}$, en particulier de l'acide acrylique, de l'acide méthacrylique, de l'acide crotonique ou de l'acide maléique.

5. Matériau d'enregistrement photosensible suivant la revendication 4, caractérisé en ce que la couche photodurcissable, destinée à former le relief, contient en tant que composant (a) un dérivé d'alcool polyvinylique hydrosoluble ou dispersible dans l'eau, obtenu par la réaction d'un poly(acétate de vinyle) ou d'un poly(propionate de vinyle) partiellement saponifié avec l'anhydride d'un acide de carboxylique à insaturation $\alpha,\beta$-oléfinique en $C_3$ à $C_{10}$ en phase hétérogène et en présence d'un catalyseur choisi parmi le p-amino-pyridines à groupe amino disubstitué telles qu'en particulier les p-dialkyl-amino-pyridines et la p-pyrrolidino-pyridine.

6. Matériau d'enregistrement photosensible suivant l'une des revendications 1 à 5, caractérisé en ce que le dérivé d'alcool polyvinylique contient en outre des groupes carboxyle libres.

7. Matériau d'enregistrement photosensible suivant l'une des revendications 1 à 6, caractérisé en ce que les dérivés d'alcool polyvinylique possèdent un poids moléculaire moyen compris dans la gamme de 10 000 à 200 000.

8. Matériau d'enregistrement photosensible suivant l'une des revendications 1 à 7, caractérisé en ce que la couche photodurcissable, destinée à former le relief, est composée de

a) 99,9 à 60 % en poids d'un dérivé d'alcool polyvinylique hydrosoluble ou dispersible dans l'eau,

b) 0,1 à 5 % en poids de photo-amorceurs et

c) 0 à 35 % en poids d'additifs et(ou) d'adjuvants non photopolymérisables usuels.